Europäisches Patentamt

**European Patent Office**

Office européen des brevets

(11) Numéro de publication : **0 086 135**
**B1**

# (12) FASCICULE DE BREVET EUROPÉEN

(45) Date de publication du fascicule du brevet :
**16.04.86**

(21) Numérc de dépôt : **83400169.5**

(22) Date de dépôt : **25.01.83**

(51) Int. Cl.⁴ : **H 03 K 17/96**

(54) **Structure de clavier capacitif.**

(30) Priorité : **29.01.82 FR 8201445**

(43) Date de publication de la demande :
**17.08.83 Bulletin 83/33**

(45) Mention de la délivrance du brevet :
**16.04.86 Bulletin 86/16**

(84) Etats contractants désignés :
**BE CH DE GB IT LI NL**

(56) Documents cités :
**DE-A- 2 746 655**
**US-A- 4 233 522**

(73) Titulaire : **COMMISSARIAT A L'ENERGIE ATOMIQUE**
**Etablissement de Caractère Scientifique Technique**
**et Industriel**
**31/33, rue de la Fédération**
**F-75015 Paris (FR)**

(72) Inventeur : **Poujois, Robert**
**Le Jaillet**
**F-38650 Sinard (FR)**

(74) Mandataire : **Mongrédien, André et al**
**c/o BREVATOME 25, rue de Ponthieu**
**F-75008 Paris (FR)**

Jouve, 18, rue St-Denis, 75001 Paris, France

## Description

La présente invention concerne une structure de clavier capacitif.

On sait que les claviers capacitifs permettent d'obtenir, par la présence d'un doigt au voisinage d'une touche sensible, l'exécution d'un ordre déterminé, l'expression « au voisinage » incluant également le cas où le doigt est en contact avec la touche sensible. De tels claviers sont de plus en plus utilisés tant pour les applications industrielles et scientifiques (pour la commande d'appareils industriels ou scientifiques), que dans les lieux ouverts au grand public et pour la commande d'appareils, par exemple électroménagers, destinés audit grand public.

On commencera d'abord, pour situer les différents problèmes que résout l'invention, par rappeler le fonctionnement connu d'un tel clavier capacitif. Les claviers capacitifs utilisent d'une façon générale le fait que la présence du doigt d'un utilisateur au voisinage d'une ou de plusieurs armatures conductrices crée des capacités électriques entre ce doigt et ces armatures et modifie ainsi les capacités existantes entre ces mêmes armatures.

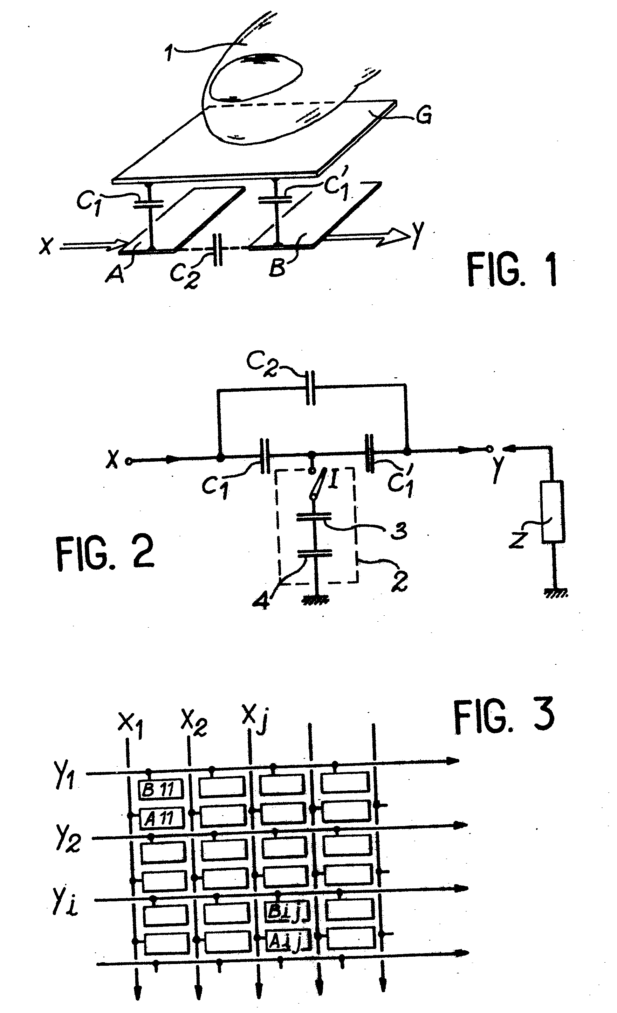

On connaît, par le brevet US-A-4 233 522 (figures 3A et 3B), de tels claviers capacitifs qui comportent, comme on le voit sous forme schématique sur la figure 1 de la présente demande, des touches sensibles G associées chacune à un couple d'électrodes sous-jacentes, à savoir d'une part une électrode A émettrice excitée séquentiellement par un signal alternatif amené par une ligne émettrice X et d'autre part, une électrode réceptrice B, couplée capacitivement à l'électrode émettrice A par la touche sensible G correspondante. Une ligne réceptrice Y recueille sur l'électrode réceptrice B, les variations de l'amplitude du signal alternatif sous l'effet de la présence éventuelle du doigt 1 de l'utilisateur situé au voisinage de la touche G.

La figure 2 représente le schéma électrique équivalent d'une telle touche et on y a figuré la ligne émettrice X ou ligne d'entrée, la ligne réceptrice Y ou ligne de sortie ainsi que deux capacités $C_1$, $C_1'$ dites « actives » et une capacité $C_2$ dite « directe ». La capacité $C_1$ représente la capacité entre l'électrode A et la touche G, la capacité $C_1'$ représente la capacité entre la touche G et l'électrode B, et la capacité $C_2$ représente le couplage capacitif direct entre l'électrode émettrice A et l'électrode réceptrice B. La présence de l'utilisateur est schématisée par une dérivation 2 (figure 2) entre le point commun aux capacités $C_1$ et $C_1'$ et la masse, cette dérivation comprenant un premier condensateur 3 d'une capacité voisine de 4 picofarads pour représenter le doigt de l'utilisateur et une capacité 4 de l'ordre de 60 picofarads pour représenter la capacité du corps de l'utilisateur par rapport à la terre. L'interrupteur I schématise par conséquent la présence ou l'absence du doigt 1 de l'utilisateur sur la touche G. Les données précédentes reposent sur la constatation expérimentale du fait que le corps d'un homme peut être représenté par un corps conducteur d'électricité qui a, par rapport à la terre, une capacité moyenne d'environ 60 picofarads lorsque cet homme porte des chaussures isolantes. Lorsque le doigt d'un utilisateur s'approche de la touche sensible G, il crée avec celle-ci une capacité qui peut varier de 2 à 5 picofarads, notamment selon le fait que ce doigt est ganté ou non, et c'est la présence de cette capacité que le clavier capacitif a pour charge de détecter.

Sur la figure 2, on a représenté également une impédance de charge Z située entre la ligne réceptrice Y et la masse, cette impédance Z représentant schématiquement l'électronique de mesure. Dans les applications connues de tels claviers capacitifs, les deux positions possibles de l'interrupteur I sont détectées en mesurant la tension recueillie aux bornes de Z, ou le courant dans l'impédance Z ou encore le déphasage entre le signal émetteur à l'entrée et le signal récepteur à la sortie. De façon générale, la présence du doigt de l'utilisateur correspondant à une dérivation du courant par la ligne 2, se traduit par conséquent par une diminution de la tension sur la ligne Y due au fait que l'impédance augmente entre l'entrée X et la sortie Y. On conçoit ainsi facilement qu'en examinant les variations précédentes sur l'impédance Z à la sortie de la ligne réceptrice Y, on parvienne à déterminer dans chaque cas celle des touches sensibles G du clavier capacitif sur laquelle s'est posé le doigt 1 de l'utilisateur.

On complétera encore la description de l'art connu en donnant quelques précisions sur la façon dont les différentes touches sensibles et électrodes émettrices et réceptrices d'un même clavier capacitif sont connectées à l'extérieur. La façon la plus simple de concevoir ces connexions, est de prévoir une ligne émettrice pour chaque électrode émettrice et une ligne réceptrice pour chaque électrode réceptrice, auquel cas, le schéma de la figure 2 est alors répété autant de fois qu'il y a de touches sensibles G dans le clavier. On conçoit néanmoins que dès qu'il s'agit d'un clavier ayant une certaine importance, cette façon de procéder conduit à un nombre de connexions très élevé, que l'on peut difficilement loger sans problème dans une même structure de clavier. C'est pourquoi, assez souvent, on a recours, comme dans le brevet US-A-4 233 522 à une alimentation et à une lecture qui se font sous forme matricielle, les différentes électrodes émettrices et réceptrices étant réparties aux sommets d'une matrice rectangulaire comme indiqué sur la figure 3 ci-jointe. Sur cette figure en effet, les différentes électrodes émettrices $A_{ij}$ et réceptrices $B_{ij}$ sont réparties en un réseau matriciel comportant des entrées $X_1$, $X_2$, ..., $X_j$, ... pour chaque colonne et des sorties $Y_1$, $Y_2$, ..., $Y_i$, ... pour chaque ligne de ce réseau matriciel. Cette figure 3 se limite au schéma de montage électrique des électrodes émettrices $A_{ij}$ et réceptrices $B_{ij}$, les différentes touches sensibles $G_{ij}$ n'étant pas figurées et devant être considérées comme situées en dehors du plan de la figure au-dessus de chacun des couples d'électrodes $A_{ij}$ et $B_{ij}$. Pour engendrer et lire les signaux issus du clavier, on utilise une alimentation alternative séquentielle qui arrive sous forme d'impulsions successivement sur chaque colonne $X_j$ alimentant du même coup toutes les électrodes $A_{ij}$ correspondant à une valeur de j déterminée. On observe alors le signal de sortie en recherchant celle des lignes $Y_i$ qui présente une diminution de signal. Quand cette observation est faite, on sait que c'est la touche $G_{ij}$ qui est actionnée si au même moment c'est la colonne $X_j$ qui est excitée par le train d'impulsions séquentielles alternatif. L'intérêt majeur de ce type de clavier matriciel réside évidemment dans la diminution du nombre de fils issus du clavier pour l'alimenter et lire les ordres qu'il reçoit.

Néanmoins, un tel clavier matriciel pose un problème de croisements des fils d'interconnexion. Ce problème est résolu dans un certain nombre de claviers où les électrodes correspondantes émettrices $A_{ij}$ et réceptrices $B_{ij}$ ne sont pas exactement dans le même plan horizontal, ce qui facilite précisément les croisements des fils d'interconnexion. Ces claviers utilisent deux couches ou substrats électriquement isolants pour leur réalisation : un premier substrat qui porte les touches sensibles sur sa face supérieure et un second substrat qui peut être un circuit imprimé, qui est situé en dessous du premier et qui porte sur une face les électrodes émettrices $A_{ij}$ avec leurs lignes $X_j$ associées et sur l'autre face, les électrodes réceptrices $B_{ij}$ avec leurs lignes $Y_i$ associées. On connaît également, d'autres claviers dont le second substrat porte sur une face les électrodes émettrices $A_{ij}$ et réceptrices $B_{ij}$ ainsi que les lignes réceptrices $Y_i$ et sur l'autre face, les lignes émettrices $X_j$ électriquement reliées aux électrodes émettrices $A_{ij}$ grâce à des trous métallisés traversant le second substrat. Ces deux types de claviers présentent donc l'inconvénient de nécessiter deux substrats pour leur réalisation, ce qui est coûteux.

Par ailleurs, l'une des qualités majeures que l'on recherche pour les claviers capacitifs réside dans leur sensibilité, qui doit être la plus élevée possible à la fois pour obtenir une réponse sans ambiguïté à chaque effleurement d'un doigt d'utilisateur, même lorsque cet utilisateur est muni de gants isolants qui diminuent fortement la capacité ajoutée par le doigt, et pour permettre également de reconnaître avec le moins de chances d'erreur possible un signal de déclenchement même en présence d'un bruit de fond parasite relativement élevé (parasite électromagnétique en provenance de la radio, des installations à haute tension) et des diverses charges par influence qui peuvent noyer un signal utile dans un environnement de bruit de fond non négligeable.

Si l'on observe à nouveau le schéma de la figure 2, on voit que parmi les causes systématiques d'affaiblissement de la sensibilité de la détection du signal figure l'existence de la capacité directe $C_2$ entre chaque couple d'électrodes émettrice A et réceptrice B. En effet, l'intensité du signal alternatif qui est dérivé par cette capacité $C_2$ échappe totalement à l'influence du doigt de l'utilisateur et correspond donc à une partie de signal perdu pour la lecture de l'information. L'existence de cette capacité $C_2$ est donc un autre inconvénient des claviers capacitifs.

La présente invention a précisément pour objet une structure de clavier capacitif qui ne présente pas les inconvénients précédents, notamment en ce qu'elle ne nécessite qu'un seul substrat, étant alors moins coûteuse que les réalisations mentionnées plus haut, et en ce qu'elle permet de diminuer la valeur de la capacité $C_2$ parasite.

De façon précise, la présente invention a pour objet une structure de clavier capacitif, comportant sur une face d'un substrat offerte à un utilisateur, une série de touches sensibles statiques associées chacune à un couple d'électrodes, à savoir d'une part une électrode émettrice excitée séquentiellement par un signal alternatif amené par une ligne émettrice et d'autre part une électrode réceptrice couplée capacitivement à l'électrode émettrice par la touche sensible statique correspondante et sur laquelle une ligne réceptrice recueille les variations du signal alternatif sous l'effet de la présence éventuelle d'un doigt de l'utilisateur au voisinage de ladite touche sensible · statique, structure caractérisée en ce que les électrodes d'un même type sont disposées sur ladite face du substrat et en ce que les électrodes de l'autre type sont disposées sur l'autre face du substrat.

Par « électrodes d'un même type », on entend les électrodes émettrices (respectivement les électrodes réceptrices), les « électrodes de l'autre type » étant alors les électrodes réceptrices (respectivement les électrodes émettrices).

On peut donc avoir une première réalisation de l'invention dans laquelle les touches sensibles et les électrodes émettrices sont disposées sur une face du substrat, des électrodes réceptrices étant alors disposées sur l'autre face et une seconde réalisation dans laquelle les touches sensibles et les électrodes réceptrices sont disposées sur une face du substrat, les électrodes émettrices étant alors disposées sur l'autre face.

On retrouve alors pour l'invention, le même schéma électrique équivalent que celui qui est représenté sur la figure 2, répété autant de fois qu'il y a de touches sensibles. Dans le cas de la première réalisation par exemple, il existe un couplage capacitif latéral entre chaque électrode émettrice A et la touche sensible G associée et, bien entendu, un couplage capacitif entre chaque électrode réceptrice B et la touche sensible G associée, qui sont situées de part et d'autre du substrat, ce dernier étant fait par exemple en un matériau diélectrique tel que le verre.

Dans la structure selon l'invention, le problème des croisements des fils d'interconnexion ne se pose plus, cette structure pouvant être matricielle ou non, et la capacité directe $C_2$ est quant à elle réduite du fait de l'épaisseur dudit substrat, cette épaisseur étant de l'ordre de 4 à 5 mm, à titre indicatif et non limitatif.

On connaît déjà, par le document DE-A-2 746 655, une structure comportant des touches mobiles au-dessus d'un substrat, et des électrodes respectivement émettrices et réceptrices, respectivement placées de part et d'autre du substrat.

Selon un mode de réalisation particulier de cette structure de clavier capacitif objet de l'invention, lesdites électrodes d'un même type entourent respectivement les touches sensibles auxquelles elles sont associées et lesdites électrodes de l'autre type sont situées respectivement en dessous des touches sensibles auxquelles elles sont associées.

Dans ce cas, les touches sensibles étant disposées suivant des rangées parallèles, pour chaque rangée lesdites électrodes d'un même type associées aux touches sensibles de cette rangée peuvent être en outre d'un seul tenant et lesdites électrodes de l'autre type peuvent être en outre disposées suivant d'autres rangées parallèles dans chacune desquelles lesdites électrodes d'un autre type sont électriquement reliées les unes aux autres, de façon à former ainsi un clavier capacitif de type matriciel.

Selon un autre mode de réalisation particulier, chacune desdites électrodes de l'autre type occupe une surface de même ordre de grandeur que la surface de la touche sensible à laquelle elle est associée.

Selon un autre mode de réalisation particulier, un blindage conducteur est prévu sur au moins l'une desdites faces et autre face du substrat. Cela permet de s'affranchir dans une très large mesure de tout bruit de fond parasite susceptible de gêner la lecture de l'état du clavier en diminuant le rapport signal/bruit. Mais cela risque également d'entraîner l'apparition de capacités parasites électriquement équivalentes à des dérivations entre les lignes réceptrices et la masse.

Selon un autre mode de réalisation particulier, les variations de l'amplitude du signal alternatif en provenance de chaque ligne réceptrice sont exploitées par un amplificateur opérationnel monté en intégrateur de courant, possédant un coefficient d'amplification en boucle ouverte élevé, de l'ordre de 10 000 à 50 000, et bouclé sur lui-même par un circuit de contre-réaction. Cela permet de rendre le clavier capacitif insensible aux capacités parasites pouvant exister notamment entre les électrodes réceptrices ou les lignes réceptrices et la masse.

En effet, le coefficient d'amplification $A_0$ étant très élevé et voisin de 50 000 par exemple, il en résulte que la tension d'entrée de l'amplificateur opérationnel monté en intégrateur de courant est $Ve = Vs/A_0$ (Vs étant la tension de sortie), c'est-à-dire que cette tension d'entrée est très petite et voisine de zéro. En d'autres termes, l'entrée de l'amplificateur de courant est à très basse impédance, ce qui signifie que pratiquement la ligne réceptrice $Y_i$ correspondante est à un potentiel très voisin de la masse. Il en résulte que le signal alternatif recueilli sur cette ligne est pratiquement insensible aux capacités parasites en dérivation entre cette ligne réceptrice $Y_i$ et la masse, capacités qui sont ainsi court-circuitées.

Selon un autre mode de réalisation particulier, pour s'affranchir des parasites électromagnétiques en provenance de l'environnement du clavier, la détection du signal alternatif en provenance d'une ligne réceptrice est effectuée en soustrayant de ce signal le signal présent sur une autre ligne de référence située dans le clavier.

La ligne de référence utilisée dans ce cas peut être de nature quelconque. Ce peut être par exemple une ligne indépendante électriquement du clavier et située dans ce dernier, éventuellement même reliée à une électrode indépendante qui reçoit de la même façon que les électrodes émettrices et réceptrices du clavier les parasites venant perturber celui-ci.

Selon un autre mode de réalisation particulier, la ligne de référence est une deuxième ligne réceptrice voisine de la première.

On conçoit que le signal parasite étant présent à la fois sur la ligne réceptrice et sur la ligne de référence, le fait d'effectuer la soustraction des deux signaux permet de s'affranchir de ce parasite.

Enfin, selon un autre mode de réalisation particulier, une couche électriquement isolante recouvre au moins lesdites électrodes d'un même type pour qu'elles ne soient pas détériorées par les utilisateurs et également pour des raisons de sécurité.

L'invention sera mieux comprise à la lecture de la description qui suit de modes de réalisation particuliers donnés à titre indicatif et non limitatif, en référence aux dessins annexés sur lesquels :

la figure 1 est une vue schématique d'un motif élémentaire de clavier capacitif connu et a déjà été décrite ;

la figure 2 est un schéma électrique équivalent d'un motif élémentaire d'une structure de clavier capacitif et a déjà été décrite ;

la figure 3 est une vue schématique d'un clavier capacitif matriciel connu et a déjà été décrite ;

la figure 4 est une vue schématique d'un mode de réalisation particulier de la structure de clavier capacitif objet de l'invention ;

la figure 5 est une vue en coupe schématique d'un mode de réalisation particulier de la structure de clavier capacitif objet de l'invention ;

la figure 6 est une vue schématique d'un circuit électronique permettant de rendre la structure de clavier capacitif objet de l'invention insensible à certaines capacités parasites, et

la figure 7 est une vue schématique dudit circuit électronique complété de façon à pouvoir fournir en sortie, un signal d'exploitation exempt d'une composante électromagnétique parasite ayant pu pénétrer dans le clavier.

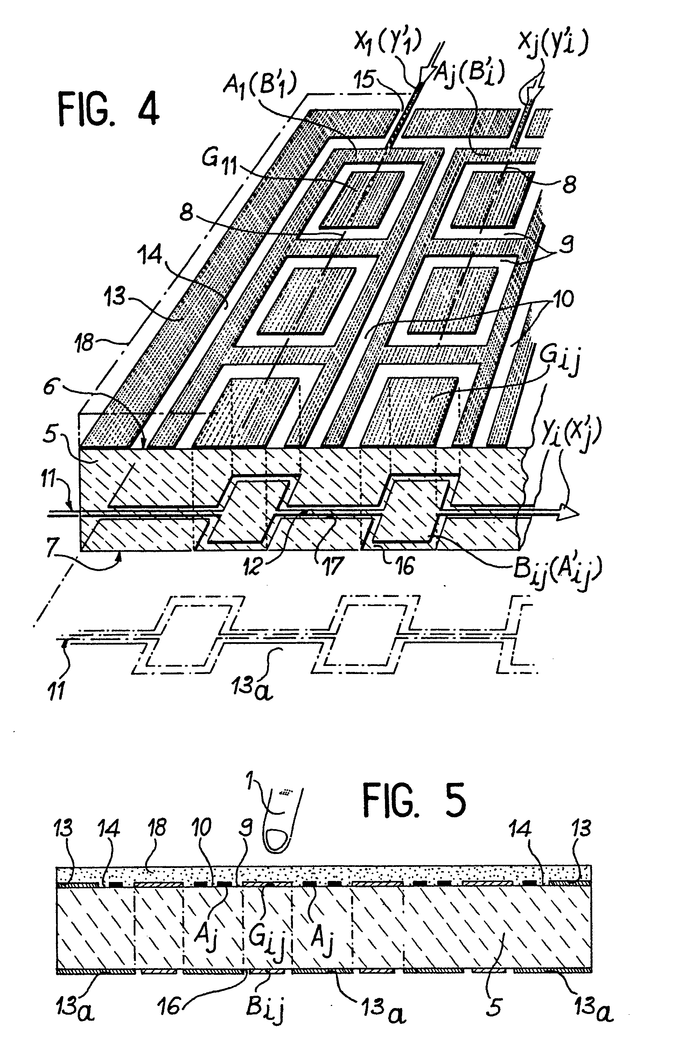

Sur la figure 4, on a représenté schématiquement un mode de réalisation particulier de la structure de clavier capacitif objet de l'invention. Ce clavier comprend un substrat isolant formé par exemple d'une plaque 5 en verre dont on ne voit qu'une partie et qui a été coupée pour la clarté de la figure. Cette plaque 5 en verre présente une face supérieure 6 sur laquelle sont disposées les touches sensibles $G_{ij}$, se présentant sous forme d'électrodes, et les électrodes émettrices $A_j$, ainsi qu'une face inférieure 7 sur laquelle sont disposées les électrodes réceptrices $B_{ij}$.

Les touches sensibles $G_{ij}$ sont disposées selon des rangées 8 parallèles entre elles. Pour chaque rangée 8, les électrodes émettrices entourent les touches sensibles $G_{ij}$, auxquelles elles sont respectivement associées, et sont en outre d'un seul tenant, c'est-à-dire non individualisées, de sorte qu'à chaque rangée 8 correspond une « multi-électrode émettrice » $A_j$ qui présente la forme d'une échelle entourant les touches sensibles $G_{ij}$ de ladite rangée, des espaces 9 électriquement isolants étant laissés entre chaque électrode émettrice $A_j$ et les touches sensibles $G_{ij}$ de la rangée 8 à laquelle cette électrode est associée. Par ailleurs, entre toutes les électrodes émettrices $A_j$ sont ménagés des espaces 10 électriquement isolants.

On voit également sur la figure 4 les lignes émettrices $X_j$ amenant lesdits signaux alternatifs aux électrodes émettrices $A_j$.

Chaque électrode réceptrice $B_{ij}$ est disposée en-dessous de la touche sensible $G_{ij}$ à laquelle elle est associée. Ces électrodes réceptrices $B_{ij}$ sont par ailleurs disposées selon d'autres rangées 11 parallèles entre elles et perpendiculaires aux rangées 8. Dans chacune de ces autres rangées 11, les électrodes réceptrices $B_{ij}$ sont électriquement reliées les unes aux autres par des lignes conductrices 12 dirigées selon lesdites autres rangées 11. On a également représenté les différentes lignes réceptrices $Y_i$ qui prolongent les lignes conductrices 12.

Le clavier capacitif ainsi obtenu est un clavier de type matriciel avec des électrodes émettrices non individualisées mais bien entendu, on pourrait également réaliser l'invention en déposant sur la plaque 5 des électrodes émettrices (respectivement réceptrices) indépendantes les unes des autres, chacune d'elles pouvant même être associée à une ligne émettrice (respectivement réceptrice).

Bien entendu également, on pourrait concevoir un clavier dans lequel les électrodes réceptrices d'une même autre rangée 11 ne seraient pas individualisées et seraient réduites à une petite bande métallique.

On peut déposer un blindage métallique 13 sur le pourtour de la face supérieure 6, en ménageant un espace 14 électriquement isolant entre ce blindage et les électrodes émettrices $A_j$ et en ménageant également des canaux 15 électriquement isolants pour le passage des lignes émettrices $X_j$. On peut de même déposer un blindage métallique 13a sur la face inférieure 7 en ménageant des espaces 16 électriquement isolants autour des électrodes réceptrices $B_{ij}$ ainsi que des canaux 17 électriquement isolants pour le passage des lignes conductrices 12. Ces blindages 13 et 13a sont par exemple réunis à un potentiel fixe pouvant être notamment celui de la masse. On s'affranchit ainsi notablement de toute influence parasite extérieure pouvant troubler la lecture de l'état du clavier.

On peut isoler les électrodes émettrices $A_j$ des utilisateurs en recouvrant la face supérieure 6 d'une couche électriquement isolante 18 qui protège par la même occasion les touches sensibles $G_{ij}$.

Sur la figure 5, on a représenté schématiquement une vue en coupe du clavier capacitif de la figure 4. On voit également sur la figure 5 le doigt 1 d'un utilisateur, placé au voisinage d'une touche sensible $G_{ij}$.

Les électrodes émettrices $A_j$ et réceptrices $B_{ij}$ ainsi que les touches sensibles $G_{ij}$ sont par exemple réalisées à l'aide d'oxydes d'indium et/ou d'étain, matériaux électriquement conducteurs et transparents que l'on peut par exemple déposer sur leurs faces respectives par voie chimique ou par une technique de dépôt sous vide, de façon connue. La couche isolante 18 a par exemple une épaisseur de l'ordre de 0,1 mm à 1 mm et peut être rapportée sur la face supérieure 6 par dépôt ou sérigraphie. Cette touche 18 peut être choisie de façon à être également transparente (cas d'une couche en $SiO_2$ ou d'une couche de plastique adhésif) ce qui permet alors de réaliser un clavier capacitif transparent ayant des applications telles que la commande de l'éclairage de points particuliers d'un panneau public disposé en dessous dudit clavier.

La surface totale d'une électrode réceptrice $B_{ij}$ et de l'espace isolant 16 qui l'entoure est par exemple égale à la surface de la touche sensible $G_{ij}$ associée, ce que l'on a figuré par des pointillés sur la figure 4. On peut alors, toujours à titre d'exemple, réaliser des touches $G_{ij}$ rectangulaires ou carrées de 15 à 35 mm de côté, entourées d'un espace isolant de 1 à 2 mm de largeur, les électrodes réceptrices $B_{ij}$ associées étant des rectangles ou des carrés entourés d'un espace isolant de 1 à 2 mm de largeur. La place est ainsi mieux utilisée dans la structure de clavier capacitif objet de l'invention que dans les claviers capacitifs connus.

Par ailleurs, dans l'invention, les capacités actives $C_1$ et $C_1'$ peuvent être facilement ajustées en jouant sur la surface d'une électrode réceptrice et sur la largeur de l'intervalle séparant une électrode émettrice de la touche sensible associée.

Revenant à la figure 4, on pourrait, bien entendu, inverser la disposition des électrodes émettrices et réceptrices : on pourrait placer sur la face supérieure 6, les électrodes réceptrices $B_i'$ dans ce cas non individualisées, associées aux lignes réceptrices $Y_i'$ et entourant les touches sensibles $G_{ij}$ et sur la face inférieure 7, les électrodes émettrices $A_{ij}'$ dans ce cas individualisées, associées aux lignes réceptrices $X_j'$ et situées en dessous des touches sensibles $G_{ij}$, les flèches de la figure 4 correspondant aux lignes $X_j'$ et $Y_i'$ étant inversées.

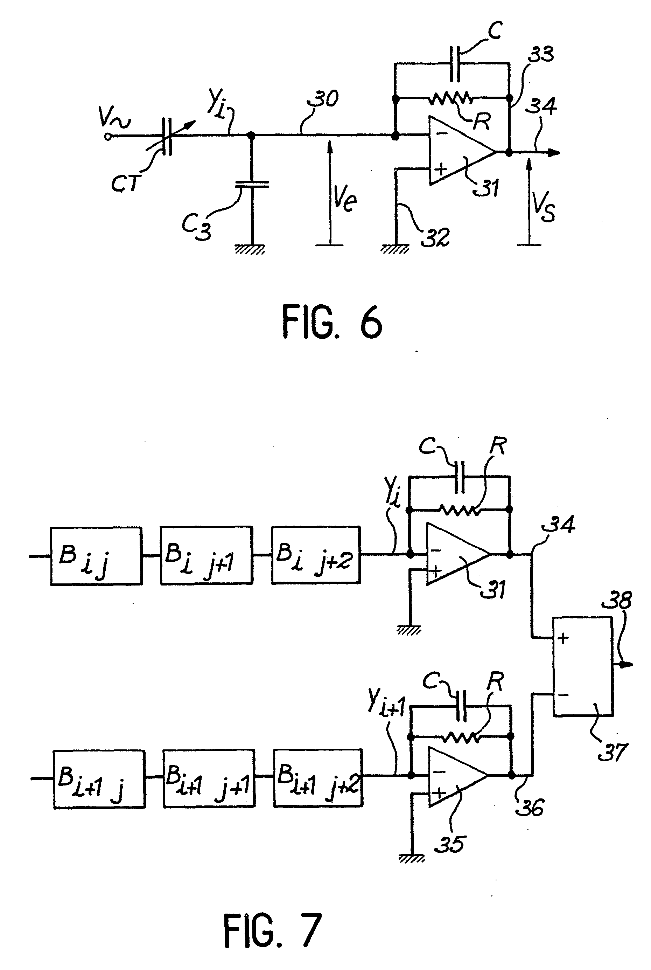

Sur la figure 6, on a représenté schématiquement un circuit électronique permettant de rendre la structure de clavier capacitif objet de l'invention insensible à certaines capacités parasites, pouvant exister notamment entre les électrodes réceptrices ou les lignes réceptrices et la masse, du fait de la présence de blindage dans le clavier capacitif.

Sur cette figure 6, on a représenté une ligne réceptrice $Y_i$ référencée 30 sur laquelle est présent un signal alternatif d'amplitude V dont il s'agit de détecter les variations possibles sous l'influence du doigt d'un utilisateur schématisé par la présence de la capacité variable CT. En dérivation entre la ligne réceptrice 30 et la masse se trouve une capacité $C_3$ qui représente l'ensemble des capacités parasites dont il s'agit de supprimer les effets. La ligne réceptrice 30 est reliée à l'entrée négative d'un amplificateur opérationnel 31 monté en intégrateur de courant et possédant un gain $A_0$ en boucle ouverte de l'ordre de 10 000 à 50 000. L'entrée positive de l'amplificateur opérationnel 31 est portée à la masse par la connexion 32 et une boucle de rétroaction 33 comportant en parallèle une capacité C et une résistance R relie la sortie et l'entrée négative de l'amplificateur opérationnel 31. La résistance R est choisie de valeur très élevée, de l'ordre par exemple de 10 MΩ, pour définir le potentiel continu d'entrée de l'amplificateur 31. Le signal utile transmis à l'électronique de lecture est alors disponible sur la sortie 34 de l'amplificateur 31. Si l'on désigne par Ve et Vs les tensions d'entrée et de sortie de l'amplificateur, on a la relation Ve = Vs/$A_0$ avec $A_0$ très peu différent de 50 000. Il en résulte que Ve est très voisin de zéro, c'est-à-dire que la tension aux bornes de la capacité $C_3$, qui représente l'ensemble des capacités parasites dont on veut s'affranchir, est très faible et donc le courant passant dans $C_3$ est négligeable. L'action de $C_3$ sur le courant pénétrant dans l'amplificateur 31 est donc pratiquement nulle. On peut encore noter que le gain de ce montage ainsi bouclé est défini par le rapport CT/C, formule dans laquelle CT est la capacité variable que représente la présence d'un doigt au voisinage d'une touche sensible.

L'utilisation d'un amplificateur opérationnel pour s'affranchir desdites capacités parasites est déjà connue, avec différents modes de réalisation particuliers, mais seulement dans le cadre de structures connues de claviers capacitifs. L'homme de l'art pourrait adapter ces différents modes de réalisation, dont celui de la figure 6 est un exemple donné à titre indicatif et non limitatif, à l'invention, sans sortir du cadre de celle-ci.

Sur la figure 7, on a représenté schématiquement le circuit électronique de la figure 6, ce circuit étant modifié de façon à s'affranchir de parasites ayant pu pénétrer dans le clavier. On retrouve sur cette figure 7 deux lignes réceptrices voisines $Y_i$ et $Y_{i+1}$ pouvant appartenir à un système de lecture matriciel du clavier et alimentant chacune l'entrée négative d'un amplificateur opérationnel, à savoir respectivement 31 et 35, chacun de ces amplificateurs opérationnels 31 et 35 comportant une boucle de rétraction conforme à celle qui a précédemment été décrite. La ligne $Y_i$ recueille les signaux en provenance des électrodes réceptrices $B_{ij}$, $B_{ij+1}$ et $B_{ij+2}$ et la ligne réceptrice $Y_{i+1}$ recueille les signaux en provenance des électrodes réceptrices $B_{i+1j}$, $B_{i+1j+1}$ et $B_{i+1j+2}$. Conformément à l'invention, les sorties des amplificateurs 31 et 35 sont reliées respectivement par les lignes 34 et 36 à un soustracteur 37 qui délivre en sortie 38 un signal exempt de toute composante parasite, puisque, si une telle composante était présente dans le clavier au moment de la mesure, elle serait présente à la fois sur la ligne $Y_i$ et sur la ligne $Y_{i+1}$ et le fait d'effectuer la soustraction des deux signaux correspondants dans le soustracteur 37 permet donc de l'éliminer.

L'utilisation d'un soustracteur pour s'affranchir desdits parasites est connue, avec différents modes de réalisation particuliers, mais seulement dans le cadre de structures connues de claviers capacitifs. L'homme de l'art pourrait adapter ces différents modes de réalisation dont celui de la figure 7 est donné à titre indicatif et non limitatif, à l'invention, sans sortir du cadre de celle-ci.

**Revendications**

1. Structure de clavier capacitif, comportant sur une face (6) d'un substrat (5) offerte à un utilisateur, une série de touches sensibles statiques ($G_{ij}$) associées chacune à un couple d'électrodes, à savoir d'une part une électrode émettrice ($A_j$ ou $A_{ij}'$) excitée séquentiellement par un signal alternatif amené par une ligne émettrice ($X_j$ ou $X_j'$) et d'autre part une électrode réceptrice ($B_{ij}$ ou $B_i'$) couplée capacitivement à l'électrode émettrice ($A_j$ ou $A_{ij}'$) par la touche sensible statique ($G_{ij}$) correspondante et sur laquelle une ligne réceptrice ($Y_i$ ou $Y_i'$) recueille les variations du signal alternatif sous l'effet de la présence éventuelle d'un doigt (1) de l'utilisateur au voisinage de ladite touche sensible statique ($G_{ij}$), structure caractérisée en ce que les électrodes d'un même type ($A_j$ ou $B_i'$) sont disposées sur ladite face (6) du substrat (5) et en ce que les électrodes de l'autre type ($B_{ij}$ ou $A_{ij}'$) sont disposées sur l'autre face (7) du substrat (5).

2. Structure de clavier capacitif selon la revendication 1, caractérisée en ce que lesdites électrodes d'un même type ($A_j$ ou $B_i'$) entourent respectivement les touches sensibles ($G_{ij}$) auxquelles elles sont associées et en ce que lesdites électrodes de l'autre type ($B_{ij}$ ou $A_{ij}'$) sont situées respectivement en dessous des touches sensibles ($G_{ij}$) auxquelles elles sont associées.

3. Structure de clavier capacitif selon la revendication 2, caractérisée en ce que, les touches

sensibles (G_{ij}) étant disposées suivant des rangées (8) parallèles, pour chaque rangée (8) lesdites électrodes d'un même type (A_j ou B_i') associées aux touches sensibles (G_{ij}) de cette rangée (8) sont en outre d'un seul tenant et en ce que lesdites électrodes de l'autre type (B_{ij} ou A_{ij}') sont en outre disposées suivant d'autres rangées (11) parallèles dans chacune desquelles lesdites électrodes d'un autre type (B_{ij} ou A_{ij}') sont électriquement reliées les unes aux autres, de façon à former ainsi un clavier capacitif de type matriciel.

4. Structure de clavier capacitif selon l'une quelconque des revendications 1 à 3, caractérisée en ce que chacune desdites électrodes de l'autre type (B_{ij} ou A_{ij}') occupe une surface de même ordre de grandeur que la surface de la touche sensible (G_{ij}) à laquelle elle est associée.

5. Structure de clavier capacitif selon l'une quelconque des revendications 1 à 4, caractérisée en ce qu'un blindage conducteur (13, 13a) est prévu sur au moins l'une desdites face (6) et autre face (7) du substrat (5).

6. Structure de clavier capacitif selon l'une quelconque des revendications 1 à 5, caractérisée en ce que les variations de l'amplitude du signal alternatif en provenance de chaque ligne réceptrice (Y_i) sont exploitées par un amplificateur opérationnel (31) monté en intégrateur de courant, possédant, un coefficient d'amplification en boucle ouverte élevé, de l'ordre de 10 000 à 50 000, et bouclé sur lui-même par un circuit de contre-réaction (33).

7. Structure de clavier capacitif selon l'une quelconque des revendications 1 à 6, caractérisée en ce que, pour s'affranchir des parasites électromagnétiques en provenance de l'environnement du clavier, la détection du signal alternatif en provenance d'une ligne réceptrice (Y_i) est effectuée en soustrayant de ce signal le signal présent sur une autre ligne de référence située dans le clavier.

8. Structure de clavier capacitif selon la revendication 7, caractérisée en ce que la ligne de référence est une deuxième ligne réceptrice (Y_{i+1}) voisine de la première (Y_i).

9. Structure de clavier capacitif selon l'une quelconque des revendications 1 à 8, caractérisée en ce qu'une couche électriquement isolante (18) recouvre au moins lesdites électrodes d'un même type (A_j ou B_i').

## Claims

1. Capacitive keyboard structure comprising, on one surface (6) of a substrate (5) directed towards a user of the keyboard, a series of touch-sensitive keys (G_{ij}) each associated with a pair of electrodes, i. e. on the one hand a transmitting electrode (A_j or A_{ij}') sequentially excited by an alternating signal conducted by a transmitting line (X_j or X_j') and on the other hand a receiving electrode (B_{ij} or B_i') capacitively coupled to the transmitting electrode (A_j or A_{ij}') by the corresponding touch sensitive key (G_{ij}) and from which a receiving line (Y_i or Y_i') collects any variations in the alternating signal resulting from the presence of a finger (1) of any user in the vicinity of said touch sensitive key (G_{ij}), said structure being characterised in that electrodes of one type (A_j or B_i') are disposed on said surface (6) of the substrate (5), and in that the electrodes of the other type (B_{ij}' or A_{ij}') are located on the other surface (7) of the substrate (5).

2. Capacitive keyboard structure according to claim 1, characterised in that the said electrodes of one type (A_j or B_i') surround the respective touch sensitive keys (G_{ij}) with which they are associated, and in that said electrodes of the other type (B_{ij} or A_{ij}') are located below the respective touch sensitive keys (G_{ij}) with which they are associated.

3. Capacitive keyboard structure according to claim 2, characterised in that, the touch sensitive keys (G_{ij}) being located in parallel ranks (8), for each rank (8), the said electrodes of the same type (A_j or B_i') associated with the touch sensitive keys (G_{ij}) of said rank (8) form a single unit, and in that said electrodes of the other type (B_{ij} or A_{ij}') are located in other parallel ranks (11) in which each of said electrodes of another type (B_{ij} or A_{ij}') are electrically interconnected whereby to form a capacitive keyboard of the matrix type.

4. Capacitive keyboard structure according to any one of claims 1 to 3, characterized in that each of said electrodes of the other type (B_{ij} or A_{ij}') occupies a surface of the same order of size as the surface of the touch sensitive key (G_{ij}) wich it is associated.

5. Capacitive keyboard structure according to any one of claims 1 to 4, characterized in that a conductive sheet (13, 13a) is provided over at least one of said surface (6) and saidother surface (7) of the substrate (5).

6. Capacitive keyboard structure according to any one of claims 1 to 5, characterized in that variations in the amplitude of the alternating signal provided by each said receiving line (Y_i) are processed by an operational amplifier (31) mounted as current integrator, having an elevated amplification coefficient in open circuit of the order of 10,000 to 50,000, and looped to itself by a feed back circuit (33).

7. Capacitive keyboard structure according to any one of claims 1 to 6, characterized in that, to eliminate parasitic electromagnetic currents from the environment of the keyboard, the detection of the alternating signal provided by the receiving line (Y_i) is effected by substracting, from said signal, the signal in another reference line located in the keyboard.

8. Capacitive keyboard structure according to claim 7, characterized in that the reference line is a second receiving line (Y_{i+1}) adjacent the first (Y_i).

9. Capacitive keyboard structure according to any one of claims 1 to 8, characterized in that at least the said electrodes of one type (A_j or B_i') are covered by an electrically-insulating layer (18).

**Patentansprüche**

1. Struktur einer kapazitiven Tastatur mit einer Reihe von statisch empfindlichen Tasten ($G_{ij}$) auf einer einem Benutzer dargebotenen Seite (6) eines Substrats (5), die jeweils einem Elektrodenpaar zugeordnet sind, nämlich einerseits einerdurch ein über eine Sendeleitung ($X_j$ oder $X'_j$) herbeigeführtes Wechselsignal sequentiell erregte Sendeelektrode ($A_j$ oder $A'_{ij}$) und andererseits einer Empfängerelektrode ($B_{ij}$ oder $B'_i$), die kapazitiv mittels der entsprechenden statisch empfindlichen Taste ($G_{ij}$) mit der Sendeelektrode ($A_j$ oder $A'_{ij}$) gekoppelt ist und an der eine Empfangsleitung ($Y_i$ oder $Y'_i$) die Änderungen des Wechselsignals aufgrund der möglichen Gegenwart eines Fingers (1) des Benutzers in der Nähe der statisch empfindlichen Taste ($G_{ij}$) aufnimmt, dadurch gekennzeichnet, daß die Elektroden einer gleichen Art ($A_j$ oder $B'_i$) auf der genannten Seite (6) des Substrats (5) angeordnet sind und daß die Elektroden der anderen Art ($B_{ij}$ oder $A'_{ij}$) auf der anderen Seite (7) des Substrats (5) angeordnet sind.

2. Struktur einer kapazitiven Tastatur nach Anspruch 1, dadurch gekennzeichnet, daß die Elektroden der gleichen Art ($A_j$ oder $B'_i$) die jeweiligen empfindlichen Tasten ($G_{ij}$) umgeben, denen sie zugeordnet sind, und daß die Elektroden der anderen Art ($B_{ij}$ oder $A'_{ij}$) jeweils unterhalb der empfindlichen Tasten ($G_{ij}$) angeordnet sind, denen sie zugeordnet sind.

3. Struktur einer kapazitiven Tastatur nach Anspruch 2, dadurch gekennzeichnet, daß die empfindlichen Tasten ($G_{ij}$) in parallelen Reihen (8) angeordnet sind, wobei bei jeder Reihe (8) die Elektroden einer gleichen Art ($A_j$ oder $B'_i$), die den empfindlichen Tasten ($G_{ij}$) dieser Reihe (8) zugeordnet sind, ferner als ein einziges Stück ausgebildet sind, und daß die Elektroden der anderen Art ($B_{ij}$ oder $A'_{ij}$) ferner längs anderer paralleler Reihen (11) angeordnet sind, wobei in jeder die Elektroden einer anderen Art ($B_{ij}$ oder $A'_{ij}$) elektrisch miteinander verbunden sind derart, daß somit eine matrixförmige, kapazitive Tastatur gebildet wird.

4. Struktur einer kapazitiven Tastatur nach einem der Ansprüche 1 bis 3, dadurch gekennzeichnet, daß jede der Elektroden der anderen Art ($B_{ij}$ oder $A'_{ij}$) eine Oberfläche der gleichen Größenordnung wie die Oberfläche der empfindlichen Taste ($G_{ij}$) einnimmt, der sie zugeordnet ist.

5. Struktur einer kapazitiven Tastatur nach einem der Ansprüche 1 bis 4, dadurch gekennzeichnet, daß eine leitende Abschirmung (13, 13a) auf wenigstens der Seite (6) oder der anderen Seite (7) des Substrats (5) vorgesehen ist.

6. Struktur für eine kapazitive Tastatur nach einem der Ansprüche 1 bis 5, dadurch gekennzeichnet, daß die von jeder Empfangsleitung ($Y_i$) herkommenden Amplitudenänderungen des Wechselsignals von einem Operationsverstärker (31) ausgewertet werden, der als Stromintegrator geschaltet ist und bei offener Schleife einen hohen Verstärkungskoeffizienten der Größenordnung von 10 000 bis 50 000 besitzt und durch einen Gegenkopplungsschaltkreis (33) mit sich selbst zur Schleife geschaltet ist.

7. Struktur einer kapazitiven Tastatur nach einem der Ansprüche 1 bis 6, dadurch gekennzeichnet, daß, um sich von den elektromagnetischen Störungen aus der Umgebung der Tastatur zu befreien, die Bestimmung des Wechselsignals von einer Empfangsleitung ($Y_i$) durchgeführt wird, indem von diesem Signal das Signal subtrahiert wird, welches auf einer anderen Bezugsleitung, die sich in der Tastatur befindet, vorliegt.

8. Struktur einer kapazitiven Tastatur nach Anspruch 7, dadurch gekennzeichnet, daß die Bezugsleitung einer zweite Empfangsleitung ($Y_{i+1}$) ist, die der ersten ($Y_i$) benachbart ist.

9. Struktur einer kapazitiven Tastatur nach einem der Ansprüche 1 bis 8, dadurch gekennzeichnet, daß eine elektrisch isolierende Schicht (18) wenigstens die Elektroden einer gleichen Art ($A_j$ oder $B'_i$) überdeckt.

FIG. 1

FIG. 2

FIG. 3

**FIG. 4**

**FIG. 5**

FIG. 6

FIG. 7

.3